# EUROPÄISCHE PATENTSCHRIFT

(11) **EP 1 910 952 B1**
(45) Veröffentlichungstag und Bekanntmachung des Hinweises auf die Patenterteilung: **20.06.2012**
(21) Anmeldenummer: 06792635.2
(22) Anmeldetag: 02.08.2006
(51) Int. Cl.: G06F 17/50

(54) **VERFAHREN ZUM ENTWERFEN EINER MASKE FÜR EINE INTEGRIERTE SCHALTUNG MIT GETRENNTER ENTWURFSREGELPRÜFUNG FÜR UNTERSCHIEDLICHE BEREICHE EINER MASKENEBENE**
METHOD FOR DESIGNING A MASK FOR AN INTEGRATED CIRCUIT HAVING SEPARATE TESTING OF DESIGN RULES FOR DIFFERENT REGIONS OF A MASK PLANE
PROCEDE POUR CONCEVOIR UN MASQUE DESTINE A UN CIRCUIT INTEGRE AVEC VERIFICATION SEPAREE DES REGLES DE CONCEPTION POUR DIFFERENTES ZONES DU PLAN DU MASQUE

(30) Priorität: 02.08.2005 DE 102005036207
(43) Veröffentlichungstag der Anmeldung: 16.04.2008
(73) Patentinhaber: X-FAB Semiconductor Foundries AG, 99097 Erfurt (DE)
(72) Erfinder: LERNER, Ralf, 99085 Erfurt (DE)
(74) Vertreter: Leonhard, Frank Reimund
(86) Internationale Anmeldenummer: PCT/EP2006/064927
(87) Internationale Veröffentlichungsnummer: WO 2007/014957

(56) Entgegenhaltungen:
- WO-A2-02/37182
- US-A- 5 442 714
- US-A1- 2002 138 813
- US-B1- 6 226 781

## Beschreibung

Die Erfindung betrifft ein Verfahren zum Entwerfen von Integrierten Schaltungen.

Zu Beginn des Herstellungsprozesses eines Halbleiterschaltkreises wird zunächst ein Schaltkreislayout entworfen, durch welches die Funktionalität des Halbleiterschaltkreises bestimmt wird. Durch das Layout wird die physische Umsetzung der Schaltung auf einem Silizium-Wafer festgelegt. Bekannte Verfahren zur Herstellung der Schaltung auf dem Wafer basieren auf Lithographie. Unter anderem wird das Schaltungslayout dabei erst auf eine Maske und anschließend durch Belichtung der Maske auf den Wafer abgebildet.

Die Herstellung eines Chips erfolgt in vielen Schritten, wobei jeder der Herstetlungsschritte eine Ungenauigkeit aufweist, die ideal bereits beim Entwurf des Layouts berücksichtigt werden sollte. Dazu sind Entwurfsregeln bereitgestellt, die beim Layoutentwurf zu beachten sind, um eine spätere Funktionalität des Layouts sicherzustellen. Beispielsweise können solche Layoutregeln den Mindestabstand zweier Transistoren oder die Breite von Metallbahnen bestimmen. Nach Fertigstellung des Schaltkreislayouts wird das Layout von einer Software auf Einhaltung der Entwurfsregeln geprüft und gegebenenfalls korrigiert. Dieser Schritt wird "Verifikation" genannt und durch einen Computer durchgeführt.

Das Schaltkreislayout enthält die benötigten Daten zur Herstellung der verschiedenen photolithographischen Masken. Diese Masken werden zur Strukturierung der unterschiedlichen Schichten im Halbleiter-Fertigungsprozess verwendet.

Aus der US-A 6,378,110 sind Verfahren bekannt, bei welchen Entwurfsebenen (Design-Ebenen) und dafür geltende Entwurfsregeln geprüft werden. Dies kann für jede Entwurfsebene und jede dazugehörige Entwurfsregel erfolgen. Dabei können prinzipiell für jede Regel alle zugehörigen Entwurfsebenen geprüft werden oder die Prüfung kann für einen Regelsatz und mehrere Entwurfsebenen erfolgen.

Wenn in einer Entwurfsebene für unterschiedliche Gebiete des späteren Maskenlayouts unterschiedliche Entwurfsregeln für den gleichen Sachverhalt zweckmäßig sind, verkompliziert sich die fehlerfreie Realisierung einer entsprechenden Maske. Am einfachsten ist es, auf die jeweilige Anpassung der Entwurfsregeln für die verschiedenen Maskengebiete zu verzichten und nur eine Entwurfsregel zu berücksichtigen, welche dann auf den kritischsten Fall angepasst ist und die übrigen Bedingungen - unter Duldung von an sich unnötigem Mehraufwand bei der späteren Realisierung des Schaltkreises - mit erfasst. Ein konkretes Beispiel soll die Metallisierungsebene eines Hochspannungs-Smart-Power-Schaltkreises sein. In diesem werden sowohl niedrige CMOS-Logikspannungen (z.B. 3,3V) als auch Hochspannung (z.B. 600V oder mehr) vorkommen. Um elektrische Überschläge zwischen Metall-Leitbahnen, die auf unterschiedlichem Potential liegen, zu verhindern, muss ein entsprechender Minimalabstand, welcher zu den Entwurfsregeln gehört, eingehalten werden, der beispielsweise bei 600V bis zu einigen Mikrometer betragen kann. Dieser aufgrund der sehr hohen Potentialdifferenzen geforderte Minimalabstand ist wesentlich größer als der in anderen Schaltungsteilen technologisch notwendige. In einer solchen Schaltung treten an den Leitbahnen im Logikteil Potentialdifferenzen von einigen Volt auf, die wesentlich geringere Abstände der Leitbahnen zulassen.

Hohes und niedriges Potential kann auch so umschrieben werden, dass es kleiner als 10V (als niedrig) und höher als 100V (als hoch) ist.

Aus der US-A 5,442,714 ist ein Verfahren bekannt, bei welchem für die Entwurfsregelprüfung die Daten einer Entwurfsebene für eine Prozessmaske des fertigen Schattkreislayouts in zwei Datenebenen A und B zerlegt werden. Diese beiden Datenebenen werden gegen die entsprechenden Entwurfsregeln A, B und AB geprüft. Die beiden Datenebenen A und B werden anschließend zu einer einzigen photolithographischen Maske verarbeitet. Bei diesem Verfahren wird die Aufteilung in zwei Datenebenen nur während der Entwurfsregelprüfung durchgeführt. Das eigentliche Layout enthält die Daten für eine Prozessmaske in einer einzigen Datenebene.

Diese Verfahrensweise ist aufwendig und beinhaltet nicht eine absolut sichere Kontrolle der Entwurfsebene. Somit ist eine weitere Layout-Kontrolle erforderlich. Fehler können aber erst am fertigen Layout entdeckt werden, was hinsichtlich der dann zu erfolgenden Korrektur einen erheblichen Aufwand darstellt.

Aus der JP-A 02-93984 ist ein Verfahren zum Entwurf von Integrierten Schaltungen bekannt, bei welchem die für eine Prozessmaskenebene verwendete Entwurfsebene in mehrere Entwurfsebenen 1 bis n aufgeteilt wird, die zu einer Gesamtebene L kombiniert werden. Bei diesem Verfahren erfolgt jedoch die Entwurfsregelprüfung (DRC als design rule check) in der kombinierten Gesamtebene L und somit können Fehler erst nach der Fertigstellung des gesamten Layouts entdeckt werden.

**Aufgabe der Erfindung** ist es daher, ein qualitativ besseres, kontrollsicheres Verfahren anzugeben, bei dem abhängig von äußeren Einflussgrößen für ein und dieselbe Prozessmaskenebene verschiedene Entwurfsregeln Verwendung finden können, wobei der Flächenbedarf auf dem Wafer (der Scheibe) wesentlich reduziert werden kann.

Diese Aufgabe wird durch die im unabhängigen Anspruch angegebenen Merkmale gelöst (Anspruch 1).

Erfindungsgemäß ist ein Verfahren zum Entwurf einer integrierten Schaltung angegeben, bei welchem eine für eine Prozessmaskenebene verwendete Entwurfsebene in mehrere Entwurfsebenen geteilt ist, wobei für jede dieser Entwurfsebenen zumindest eine eigene Entwurfsregel gilt, und wobei die Entwurfsregeln von jeder der eigenständigen Entwurfsebenen in einer Entwurfsregelprüfung in einem weiteren Verfahrensschritt einzeln verifiziert wird und erst danach die mehreren geprüften Entwurfsebenen zu einer einzigen Datenebene kombiniert werden. Anschließend wird aus dieser kombinierten Datenebene eine einzige Prozessmaske hergestellt.

Das erfindungsgemäße Verfahren ermöglicht es, abhängig von äußeren Einflußgrößen für eine Entwurfsebene unterschiedliche Designregeln für den gleichen Sachverhalt festzulegen und anhand von mehreren dieser zugeordneten vereinzelten Entwurfsebenen einfacher zu prüfen. Darüber hinaus ist es möglich, wenn sich die Entwurfsregeln auf die geometrischen Eigenschaften der Polygone, durch welche die Bauelemente einer Integrierten Schaltung dargestellt werden, sowie deren geometrischen Verhältnisse untereinander beziehen, den Flächenbedarf der Bauelemente wesentlich zu reduzieren.

Als besonders vorteilhaft bei dem erfindungsgemäßen Verfahren wird angesehen, dass jede der (aufgeteilten) Entwurfsebenen im Gesamtschaltungslayout Verwendung findet.

Mit der "Aufteilung" der Entwurfsebene für die Prozessmaskenebene in die mehreren Entwurfsebenen, die normalerweise stattfindet, ist der Zustand gemeint, zu dem mit den mehreren Entwurfsebenen gearbeitet wird. In den mehreren Entwurfsebenen wird das jeweilige Layout getrennt gestaltet, so dass die Aufteilung eine Trennung ist, mit anderen Worten auch zwei getrennte Entwurfsebenen vorliegen oder "in diese aufgeteilt ist", in denen jeweils zumindest eine eigene Entwurfsregel gilt (Anspruch 1, Anspruch 10). Deutlicher kommt das zum Ausdruck, wenn bereits mehrere Entwurfsebenen aufgeteilt vorliegen, die zuvor, bei der Erstellung der Designunterlagen, Konzeptionierung usw. bereits erfolgte. Die Aufteilung der einen Entwurfsebene ist also vorgelagert oder man geht bereits davon aus, wenn das Layout in der jeweilig eigenständigen Entwurfsebene erfolgt.

Wenn die Prozessmaskenebene eine Metallisierungsebene betrifft, zur Herstellung von Leitbahnen in einer Hochvolt-Smart-Power-Schaltung, bei welcher die Leitbahnen für unterschiedliche Potentiale vorgesehen und geeignet sind, werden vorzugsweise Leitbahnen für hohes Potential in einer ersten Entwurfsebene entworfen und Leitbahnen für niedriges Potential in einer zweiten Entwurfsebene, und wobei für jede dieser Entwurfsebenen zumindest eine unterschiedliche Entwurfsregel gilt. Somit kann der Flächenbedarf der Leitbahnen bis auf ein Minimum reduziert werden.

Das hohe und das niedrige Potential darf so verstanden werden, wie zum Stand der Technik erklärt.

Die beiden Entwurfsebenen, für die jeweils zumindest eine Entwurfregel gilt, und diese zumindest zwei Regeln nicht gleich sind, gelten vorzugsweise für dieselbe Metallisierungsebene zur Herstellung von Leitbahnen in einer Hochvolt-Smart-Power-Schaltung.

Vorzugsweise wird ein geometrisches Verhältnis, insbesondere ein Minimalabstand, zwischen den Leitbahnen eines Hochspannungs-Smart-Power-Schaltkreises als Entwurfsregel festgelegt, um elektrische Überschläge zwischen Leitbahnen, welche im Betrieb der Schaltung auf unterschiedlichem Potential liegen, zu verhindern.

Zwischen Leitbahnen, von denen mindestens eine für hohes Potential vorgesehen ist, und die in einer ersten Entwurfsebene entworfen werden, wird ein großerer erster Minimalabstand als Entwurfsregel festgelegt als ein zweiter Minimalabstand zwischen Leitbahnen, die ausschließlich für niedriges Potential vorgesehen sind, und in einer zweiten Entwurfsebene entworfen werden.

Vorzugsweise werden die erste und die zweite Entwurfsebene in einer einzigen Prozessebene zu einer einzigen photolithographischen Prozessmaske gefertigt oder zusammen geführt. Mehrere Ebenen, also auch eine dritte und vierte Ebene kann hinzutreten. Die erste und die zweite Ebene sind lediglich Namen und keine Schranken hinsichtlich ihrer Zahl.

Damit kann eine integrierte Schaltung mit einem Gesamtschaltungslayout geschaffen werden, bei welcher das Gesamtschaltungslayout aus mehreren getrennten und nach eigenen Entwurfsregeln geprüften Entwurfsebenen besteht, wobei diese einzeln geprüften Entwurfsebenen zu einer einzigen Datenebene kombinierbar sind, um eine einzige Prozessmaske zu bilden. Die getrennten Ebenen können schon vorher bei der Erstellung der Designunterlagen, Konzeptionierung usw. aufgeteilt worden sein. Sie können auch als jeweilige eigene/getrennte Ebenen vorliegen.

Erfindungsgemäß ist das Verfahren zum Entwurf von Integrierten Schaltungen angegeben, bei welchem die für eine Prozessmaskenebene verwendete Entwurfsebene in mehrere Entwurfsebenen getrennt vorliegt (aufgeteilt wird), für jede dieser Entwurfsebenen eigene Entwurfsregeln gelten, die auch in der Entwurfsregelprüfung einzeln verifiziert werden, wobei danach die mehreren geprüften Entwurfsebenen zu einer einzigen Datenebene kombiniert werden und anschließend aus dieser kombinierten Datenebene eine einzige Prozessmaske hergestellt wird, und wobei jede dieser Entwurfsebenen im Gesamtlayout Verwendung findet.

Bevorzugte Ausführungsbeispiele der Erfindung werden nachfolgend Bezug nehmend auf die Zeichnungen näher erläutert. Dabei zeigt
- Fig. 1: einen Ausschnitt nur einer Entwurfsebene der Metallisierung eines Hochspannungs-Smart-Power-Schaltkreises nach dem Stand der Technik.
- Fig. 2: einen Ausschnitt aus einer ersten und einen Ausschnitt aus einer zweiten Entwurfsebene der Metallisierung eines Hochspannungs-Smart-Power-Schaltkreises gemäß einem Ausführungsbeispiel der Erfindung.
- Fig. 3: einen Ausschnitt aus der Prozessmaske der Metallisierungsebene gemäß Figur 2.
- Fig. 4a Fig. 4b: symbolisieren die beiden Entwurfsebenen NV (als Niedervolt-Ebene) und HV (als Hochvolt-Ebene), die in Figur 2 gemeinsam mit dem jeweiligen Regel-Abstand 6, 7 gezeigt sind. Der Abstand 7 bezieht sich auf die Niedervolt-Ebene, der Abstand 6, welcher größer ist, bezieht sich auf die Hochvolt-Ebene. Diese beiden Ebenen sind logische Entwurfsebenen. Sie werden in einer Datenebene für die Maskenherstellung zusammengefasst, was die Figur 2 symbolisiert.

In der nachfolgenden Beschreibung werden gleiche und gleich wirkende Teile mit denselben Bezugsziffern bezeichnet. Die in den Zeichnungen dargestellten Elemente sind nicht maßstabsgetreu gezeichnet.

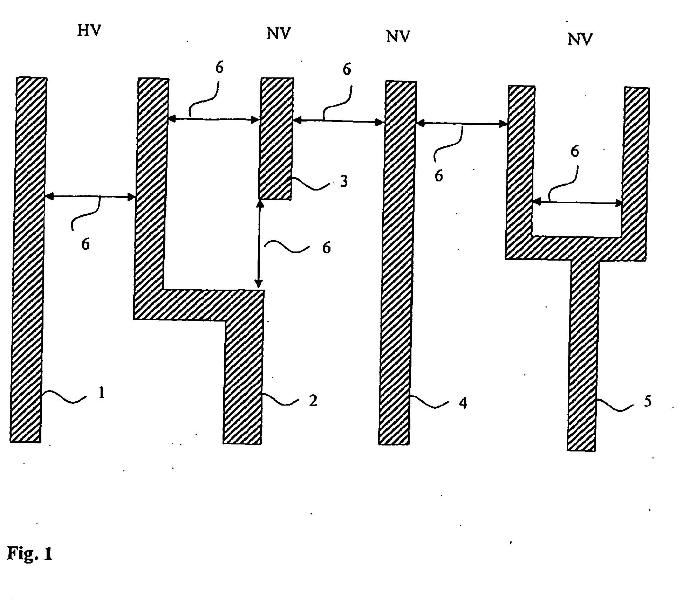

Figur.1 zeigt einen Ausschnitt einer einzigen Entwurfsebene der Metallisierung eines Hochspannungs-Smart-Power-Schaltkreises nach dem Stand der Technik. Die Entwurfsebene weist eine erste Leitbahn 1 und eine zweite Leitbahn 2 mit hohem Potential HV sowie eine erste Leitbahn 3, eine zweite Leitbahn 4 und eine dritte Leitbahn 5 mit niedrigem Potential NV auf. Das hohe Potential erfordert einen großen Mindestabstand zwischen den Leitbahnen, um elektrische Überschläge zwischen den Leitbahnen, die auf unterschiedlichem Potential liegen, zu verhindern. Wie aus Figur 1 ersichtlich ist, ist der Minimalabstand 6 zwischen den Leitbahnen 1, 2, 3, 4 und 5, die auf unterschiedlichem Potential liegen, überall gleich und entspricht dem für die höhere Spannung der HV Ebene.

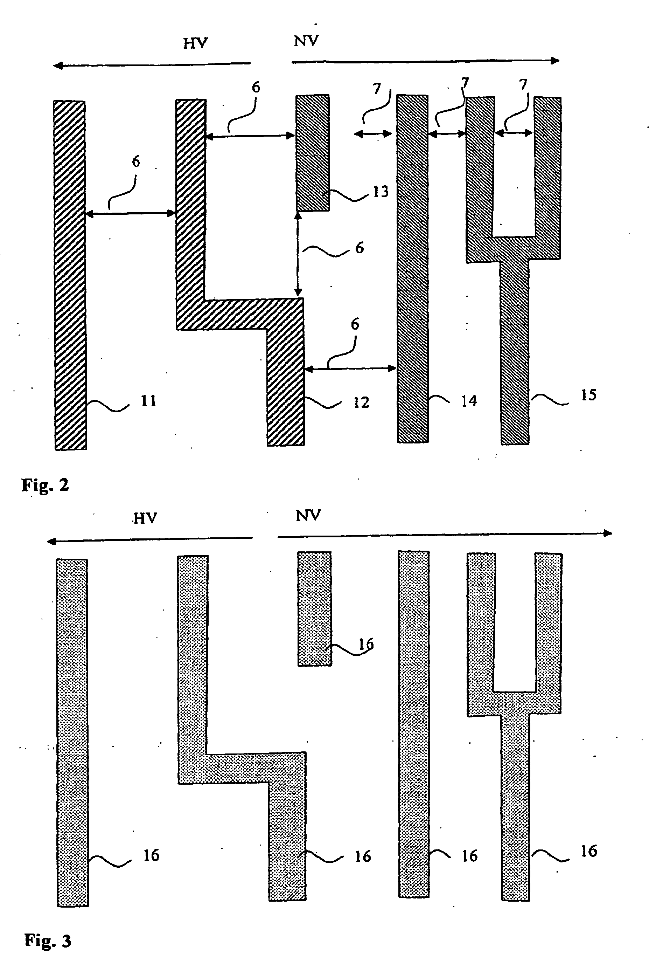

**Figur 2** zeigt einen Ausschnitt aus einer ersten und einen Ausschnitt aus einer zweiten Entwurfsebene der Metallisierung eines Hochspannungs-Smart-Power-Schaltkreises gemäß einem Ausführungsbeispiel der Erfindung, vgl. dazu **Figur 5.**

Eine Trennung der Entwurfsebenen aus einer Entwurfsebene heraus, wobei die eine Entwurfsebene für die Prozessmaske vorgesehen ist, muss nicht ein echter Schritt des Verfahrens sein. Die Ebenen, in welchen das Layout stattfindet, können auch von sich aus getrennt sein, im Sinne von "geteilten oder aufgeteilten" Entwurfsebenen. Der eventuelle Schritt der Aufteilung ist entweder gar nicht vorhanden, sondern nur Ergebnis, so dass eine Aufteilung vorliegt, mit welchen getrennten Entwurfsebenen gearbeitet wird, oder aber die Aufteilung in mehreren Entwurfsebenen erfolgte bereits vorher, bei der Erstellung von Designunterlagen, Konzeptionierung usw., bezogen auf die integrierte Schaltung, insbesondere die Prozessmaskenebene für die Metallisierungsebene, in der die Leitbahnen liegen.

Leitbahnen 11 und 12 sind für ein hohes Potential HV vorgesehen (und deshalb dafür "geeignet") und werden in einer ersten Entwurfsebene, welche die Metallisierungsebene betrifft, entworfen. Dabei ist als eine von beispielsweise mehreren Entwurfsregeln der Minimalabstand 6 zwischen den Leitbahnen 11 und 12 festgelegt.

Soweit von Leitbahnen gesprochen wurde, sind diese datenmäßige Repräsentanten dieser Leitbahnen, die erst tatsächlich durch Abbilden der Maske aus der Maskenebene in einem beispielsweise Lithographieverfahren bei der physischen Umsetzung der Schaltung im Wafer entstehen. Dort in der Metallisierungsebene, respektive zu dem Zeitpunkt, zu dem die Metallisierungsebene per Lithographie in das Bauteil übertragen wird. Zur Vereinfachung des Verständnisses wird hier jeweils von Leitbahnen 11, 12 (Hochvolt-Ebene HV) oder Leitbahnen 13 bis 15 (Niedervolt-Ebene NV) gesprochen, aber deren jeweilige Repräsentanten in der jeweiligen logischen Entwurfsebene gemeint. Diese Repräsentanten sind Strukturen, welche in ihrer Form den späteren Strukturen in der Metallisierungsebene der Halbleiterscheibe entsprechen, um einen Beitrag zur Entstehung der integrierten Schaltung zu leisten. Diese Strukturen auf der Maske können in ihrer Größe gegenüber den realen Strukturen abweichen, aber die Form bleibt dieselbe, so dass sie mathematisch ähnlich sind, z.B. bei einer Belichtung 1:1 würde die Struktur auf der Maske identisch in die Struktur der Metallisierungsebene übertragen, bei einer 5:1 Belichtung würden die Maskenstrukturen um den Faktor 5 verkleinert auf die Scheibe, beispielsweise in der Metallisierungsebene belichtet.

Es gibt mehrere Metallisierungsebenen auf der Scheibe, beispielsweise eine bis 10V, eine für 100V, eine weitere für 300V und eine noch weitere für die Verwendung mit Spannungen oberhalb von 300V. Ebenso wie mehrere Ebenen vorhanden sein können, sind auch mehrere verschiedene Spannungen in einer Ebene möglich, wobei hier als Ebene die Metallisierungsebene gemeint ist. Die beispielhaft drei Ebenen sind aber nicht beschränkend, sondern nur ein weiteres Beispiel, wie mehrere Ebenen jeweils eigenständig entworfen und im Layout einer Verifikation unterworfen werden.

In einer zweiten Entwurfsebene, welche die Metallisierungsebene betrifft, werden Leitbahnen 13, 14 und 15 entworfen, die ein niedriges Potential NV aufweisen werden (im Betrieb). Zwischen diesen Leitbahnen 12, 13 und 14, wird ein deutlich reduzierter Minimalabstand 7 als eine andere von mehreren hier geltenden Entwurfsregeln festgelegt und verwendet, was zu einer wesentlichen Reduzierung des Flächenbedarfs der späteren Maske und Leiterbahnen führt.

Die erste und die andere Regel sind nicht gleich. Im genannten Beispiel ist der Minimalabstand 7 kleiner, bezogen auf Leitbahnen, die in der Metallisierungsebene des fertigen Bauteils näher beieinander liegen dürfen, und bezogen auf Minimal-Abstände 6, die als Regel für die Hochvolt-Ebene gelten, und hier den Leitbahnen anhaftet, die in der HV-Ebene bei der Reproduktion über die Maske und das Lithographieverfahren in der Metallisierungsebene entstehen.

Für die Herstellung der fotolithografischen Maske werden die beiden Entwurfsebenen zu einer einzigen Datenebene für eine Maskenebene zusammengefasst.

Beim Zusammenführen der beiden Entwurfsebenen wird der größere Minimalabstand 6 zwischen den aneinander angrenzenden Leitbahnen, hier Leitbahnen 6 und 13 bzw. 14, welche unterschiedliche Potentiale haben werden, beibehalten, was aus Figur 2 deutlich zu sehen ist.

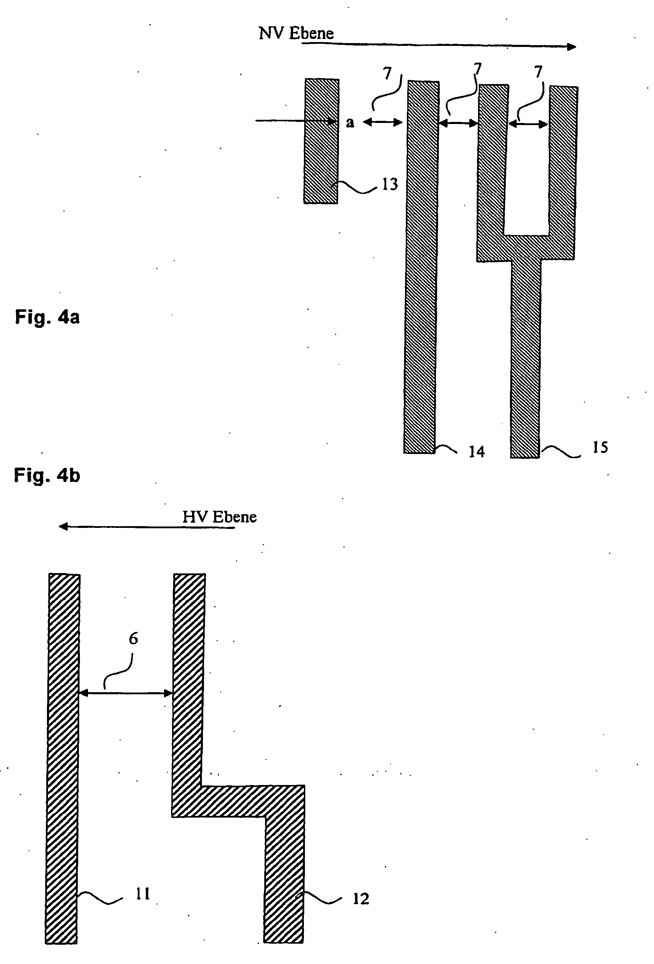

**Figur 3** zeigt die im Herstellungsprozess in einer einzigen (nicht dargestellten) Prozessebene mit einer einzigen fotolithografischen (nicht dargestellten) Prozessmaske zusammengeführten Entwurfsebenen, wobei alle Leitbahnen 16 auf der Fotomaske die in Figur 2 gezeigten und oben erwähnten Minimalabstände 6 bzw. 7 aufweisen. Diese Minimalabstände sind bereichsweise unterschiedlich und sie sind getrennt entworfen worden, welche Trennung die beiden Entwurfsebenen der Figur 4a (Niedervolt-Ebene) und Figur 4b (Hochvolt-Ebene) zeigen. Die jeweilige Entwurfsregel ist dort zu erkennen, mit den beispielsweise zwei Bahnen 11, 12 in der Hochvolt-Ebene und mit den beispielsweise drei Bahnen bzw. einer gesplitteten Y-förmigen Bahn in der Niedervolt-Ebene der Figur 4a.

Die Ausnahme in dem angrenzenden Abschnitt ist der größere Abstand 6 bei denjenigen Bahnen 14, 12, welche in Figur 2 aneinander angrenzen (einander direkt benachbart sind). Die angrenzenden Leitbahnen sind diejenigen, welche sich genau gegenüber liegen, so dass es eigentlich die Leitbahnen 12 und 13 sind, aber eine andere Leitbahn 14 dort, wo die Leitbahn 13 aufhört, die nächstliegende und benachbarteste Leitbahn der Niedervolt-Ebene gegenüber der letzten Leitbahn der Hochvolt-Ebene ist. Für diese, teils auch gestaffelte Abfolge von benachbarten Leitbahnen gilt übergreifend die Übergangs-Bemessungsregel, dass der größere Abstand 6 zu erfüllen ist, von allen Leitbahnen, die an der äußeren Grenze der Niedervolt-Ebene liegen und benachbart zu der äußeren Grenze der Hochvolt-Ebene sind, mit Bezug zur HV-Ebene.

Die DRC (als Designregel) definieren z.B. die erläuterten Mindestabstände. Ein Abstand zwischen der Leitbahn 13 und der Leitbahn 14 ist dabei zumindest so groß wie durch den Abstandspfeil 7 in Figur 2 verdeutlicht. Dies betrifft unter Berücksichtigung einer entsprechenden Verkleinerung oder Vergrößerung bei der Abbildung der Maskenebene in die Scheibe einer entsprechenden Größe auf der Maskenebene. Im Beispiel soll ein Abbildungsverhältnis von 1:1 angenommen werden und die Strukturen, welche in der Maskenebene dem Layout unterliegen, werden sinngemäß auch als "Leitbahn" bezeichnet, obwohl sie nur ihre Repräsentanten sind. Der genannte Abstand 7 in Figur 2, der zwischen dem oberen Abschnitt der Leitbahn 14 und der kürzeren Leitbahn 13 ist, kann auch größer gewählt werden. Im abgebildeten Anwendungsfall könnte die Leitbahn 13 auch ein Stück nach rechts verschoben werden, wodurch sie einen größeren Abstand zur Leitbahn 12 erhielte (deren oberen Abschnitt), und dieser größere Abstand ist größer als der Mindestabstand der zweiten Entwurfsregel für die Hochvolt-Ebene. Dadurch ergeben sich auch weitere Ausführungen für die Gestaltung mit der Leitbahn 13, die zwischen der Hochvolt-Ebene (dem abgebildeten Hochvolt-Bereich in beispielsweise der Metallisierungsebene) und dem Niedervolt-Bereich, welcher der Niedervolt-Entwurfsebene entspricht.

Wird die Leiterbahn 13 als kürzeres Stück weiter nach rechts im Layout entworfen, muss auf die rechts weiter geltende Entwurfsregel geachtet werden, dass der Abstand 7 nicht unterschritten werden darf. Der Abstand 6 wird dann auch nicht unterschritten (links von der Leitbahn 13), so dass beide Entwurfsregeln erfüllt sind.

Für die im Layout zu legende Leitbahn 13 ist aufgrund der abgebildeten abgewinkelten Form der Leitbahn 12 also eine Vielzahl von Möglichkeiten gegeben, von denen die am weitesten links liegende Bahn eingezeichnet ist und sinngemäß die am rechtesten liegende Variante dort ist, wo der rechte Rand der Leitbahn 13 an das linke Pfeilende des eingezeichneten Abstands 7 stößt.

Es ergibt sich daraus für den oberen Abschnitt dieses Layouts in Figur 2, dass entweder zwischen den Leitbahnen 12,13 oder zwischen den Leitbahnen 13 und 14 oder zwischen jeweils beiden Paaren von Leitbahnen größere Abstände entstehen als die vorgegebenen Mindestabstände 6 und 7. Beide Verifikationen werden somit erfüllt, mehrere Layouts sind möglich und der Platzbedarf, der eingenommen wird, ist für keine der mehreren möglichen Layouts schlechter zu bewerten.

Der Mindestabstand 6 im unteren Abschnitt zwischen den Leitbahnen 12,13 definiert die Notwendigkeit, hier ist der Abstand 6 vorzusehen als Mindestabstand zwischen dem Hochvolt-Bereich und dem Niedervolt-Bereich, die demgegenüber kürzere Leitbahn 13 hat weiter oben mehrere mögliche Lagen im Layout.

Die genannte "Übergangs-Bemessungsregel" ist also wesentlich toleranter und erlaubt je nach Verlauf der Leitbahnen mehrere Gestaltungen, wird aber geprägt von dem Hochvolt-Bereich und der zugehörigen Hochvolt-Ebene, die ihren Mindestabstand 6 so legen muss, dass zumindest dieser von der am weitesten außen befindlichen Leitbahn der Niedervolt-Ebene (des Niedervolt-Bereichs in Halbleiter) eingehalten wird. Mit anderen Worten gilt die Entwurfsregel für die Hochvolt-Ebene auch für den Übergangsbereich zur Niedervolt-Ebene. Daraus folgt, dass der Abstand "a" in Figur 4a einen Spielraum eröffnet, in dessen Rahmen alle Design-Regeln von beiden Ebenen weiterhin erfüllt bleiben.

Ein Computerprogramm, das einen Programmcode aufweist, beinhaltet die Verifizierungen jeder einzelnen der getrennt entworfenen Entwurfsebenen. Die erste Regel und zumindest eine davon abweichende Regel betreffend zwei Entwurfsebenen und das Programm verifiziert das entworfene Layout der ersten Entwurfsebene mit der zumindest einen Entwurfsregel und verifiziert die zweite Entwurfsebene mit der zumindest einen anderen Entwurfsregel, um diese getrennt verifizierten Entwurfsebenen für die Zusammenführung in der einzigen kombinierten Datenebene brauchbar zu machen.

Es ergibt sich daraus eine integrierte Schaltung, die auch mit anderen Prozessschritten bearbeitet und hergestellt wird, aber u.a. die Metallisierungsebene aufweist, die aus dem Gesamtschaltungs-Layout der mehreren Entwurfsebenen stammt, die getrennt behandelt worden sind, getrennt verifiziert worden sind und dabei jede mit ihrer zumindest einen Entwurfsregel verifiziert wurde, welche beiden genannten Entwurfsregeln unterschiedlich sind.

Wenn andere Parameter der Entwurfsregeln auch vorhanden sind, kann das durchaus der Fall sein. Diese müssen nicht zwingend abweichend sein, sondern zumindest eine Regel weicht ab, so dass man die beiden Sätze von Entwurfsregeln für die eine Hochvolt-Ebene und die andere Niedervolt-Ebene als nicht gleich bezeichnen kann.

Im Beispiel sind das beispielsweise die Abstände der Leitbahnen. Andere Entwurfsregeln können die Breite der Leitbahnen betreffen.

### Bezugszeichen.

- 1: Erste Leitbahn mit hohem Potential in einer einzigen Entwurfsebene (Metallisierungsebene)
- 2: Zweite Leitbahn mit hohem Potential in einer einzigen Entwurfsebene (Metallisierungsebene)
- 3: Erste Leitbahn mit niedrigem Potential in einer einzigen Entwurfsebene (Metallisierungsebene)
- 4: Zweite Leitbahn mit niedrigem Potential in einer einzigen Entwurfsebene (Metallisierungsebene)
- 5: Dritte Leitbahn mit niedrigem Potential in einer einzigen Entwurfsebene (Metallisierungsebene)
- 6: Minimalabstand für Leitbahnen mit hohem Potential
- 7: Minimalabstand für Leitbahnen mit niedrigem Potential
- 11: Erste Leitbahn mit hohem Potential in einer ersten Entwurfsebene (Metallisierungsebene)
- 12: Zweite Leitbahn mit hohem Potential in einer ersten Entwurfsebene (Metallisierungsebene)
- 13: Erste Leitbahn mit niedrigem Potential in einer zweiten Entwurfsebene (Metallisierungsebene)
- 14: Zweite Leitbahn mit niedrigem Potential in einer zweiten Entwurfsebene (Metallisierungsebene)
- 15: Dritte Leitbahn mit niedrigem Potential in einer zweiten Entwurfsebene (Metallisierungsebene)
- 16: "Leitbahnen" auf Fotomaske.

## Patentansprüche

1. **Verfahren zum Entwerfen** einer Integrierten Schaltung oder Herstellung einer Prozessmaske für eine solche integrierte Schaltung,
- bei welchem Verfahren eine für eine Prozessmaskenebene verwendete Entwurfsebene in mehrere getrennte Entwurfsebenen (HV,NV) aufgeteilt ist oder in mehrere getrennte Entwurfsebenen aufgeteilt wird und für jede der mehreren getrennten Entwurfsebenen ein jeweiliges Layout getrennt gestaltet wird; wobei
- für jede dieser getrennten Entwurfsebenen (HV,NV) zumindest eine Entwurfsregel (6,7) unterschiedlich also anders ist;
- die zumindest eine unterschiedliche Entwurfsregel für jede der getrennten Entwurfsebenen (HV,NV) nach der getrennten Gestaltung des jeweiligen Layouts In einer eigenen Entwurfsregelprüfung für die jeweilige getrennte Entwurfsebene mit dem jeweiligen gestalteten Layout einzeln verifiziert wird und erst danach die mehreren verifizieren, getrennten Entwurfsebenen zu (HV,NV) einer einzigen Datenebene kombiniert werden;
- anschließend aus dieser kombinierten Datenebene eine Prozessmaske hergestellt wird, welche den getrennt verifizierten Entwurfsebenen mit den jeweiligen getrennt gestalteten Layouts kombiniert entspricht;
wobei die Prozessmaskenebene eine Hochvolt Smart-Power Prozessmaskenebene ist, vorgesehen für die Herstellung von Leit(er)bahnen (11 bis 15) in einer Hochvolt Smart-Power-Schaltung, bei welcher die Leitbahnen für unterschiedliche Potentiale geeignet und vorgesehen sind, , wobei erste (11,12) der Leitbahnen für hohes Potential in einer ersten Entwurfsebene (HV) und zweite (13 bis 15) der Leitbahnen für niedriges Potential, ungeeignet für das hohe Potential, in einer zweiten Entwurfsebene (NV) entworfen werden, und wobei für jede dieser zwei Entwurfsebenen zumindest eine nicht gleiche Entwurfsregel (6,7) gilt.

2. Verfahren nach Anspruch 1, wobei jede der aufgeteilten Entwurfsebenen (NV, HV) im Gesamtschaltungslayout verwendet wird.

3. Verfahren nach Anspruch 1, wobei die Prozessmaskenebene eine Metallislerungsebene ist.

4. Verfahren nach Anspruch 1, wobei ein geometrisches Verhältnis zwischen den Leit(er)bahnen (11 bis 15), insbesondere ein Minimalabstand (6,7) als Entwurfsregel festgelegt wird, um elektrische Überschläge zwischen Leitbahnen, die auf unterschledlichen Potentialen (HV,NV) liegen, zu verhindern.

5. Verfahren nach einem der vorhergehenden Ansprüche
wobei zwischen den ersten Leit(er)bahnen (11,12), von denen mindestens eine für hohes Potential geeignet, vorgesehen und verwendbar ist und die in der ersten Entwurfsebene entworfen werden, ein größerer Minimalabstand (6) als Entwurfsregel festgelegt wird als ein Minimalabstand (7) zwischen den zweiten Leitbahnen (13,14,15), die ausschließlich für niedriges Potential, ungeeignet für das hohe Potential vorgesehen sind, und in der zweiten Entwurfsebene entworfen werden.

6. Verfahren nach einem der vorhergehenden Ansprüche, wobei die erste und die zweite Entwurfsebene in einer einzigen Prozessebene mit einer einzigen photolithographischen Prozessmaske gefertigt werden.

7. Verfahren nach Anspruch 1, wobei die beiden Entwurfsebenen (NV,HV) für dieselbe Metallisierungsebene gelten.

8. Verfahren nach Anspruch 1, wobei die beiden Entwurfsebenen (HV,NV) eine Metallisierungsebene im Wafer oder in der Scheibe betreffen.

## Claims

1. Method for designing an integrated circuit or producing a process mask for such an integrated circuit,
- in which method a design plane used for a process mask plane is divided up into several separate design planes (HV, NV) or is divided up into several separate design planes and for each of the several separate design planes, a particular layout is arranged to be separate; wherein
- for each of these separate design planes (HV, NV), at least one design rule (6, 7) is variable, that is different;
- the at least one variable design rule for each of the separate design planes (HV, NV) is verified individually after the separate arrangement of the particular layout in a separate design rule test for the particular separate design plane with the particular arranged layout and only then are the several verified, separate design planes combined to form (HV, NV) of a single data plane;
- then from this combined data plane, a process mask is produced which corresponds to the separately verified design planes combined with the particular separately arranged layouts;
wherein the process mask plane is a high-volt smart-power process mask plane, intended for the production of conducting(conductor) tracks (11 to 15) in a high-volt smart-power circuit, in which the conducting tracks are suitable and intended for variable potentials, wherein first (11, 12) of the conducting tracks are designed for high potential in a first design plane (HV) and second (13 to 15) of the conducting tracks for low potential, unsuitable for high potential, in a second design plane (NV), and wherein for each of these two design planes, at least one non-equal design rule (6, 7) applies.

2. Method according to claim 1, wherein each of the divided-up design planes (NV, HV) is used in the overall circuit layout.

3. Method according to claim 1, wherein the process mask plane is a metallisation plane.

4. Method according to claim 1, wherein a geometric ratio is established between the conducting (conductor) tracks (11 to 15), in particular a minimum distance (6, 7) as a design rule, to prevent electrical spark-overs between conducting tracks which are at variable potentials (HV, NV).

5. Method according to one of the preceding claims, wherein between the first conducting(conductor) tracks (11, 12), of which at least one is suitable, intended and can be used for high potential, and which are designed in the first design plane, a greater minimum distance (6) is established as a design rule than a minimum distance (7) between the second conducting tracks (13, 14, 15), which are intended only for low potential, unsuitable for high potential, and are designed in the second design plane.

6. Method according to one of the preceding claims, wherein the first and the second design planes are manufactured in a single process plane with a single photolithographic process mask.

7. Method according to claim 1, wherein the two design planes (NV, HV) apply for the same metallisation plane.

8. Method according to claim 1, wherein the two design planes (HV, NV) relate to a metallisation plane in the wafer or in the slice.

## Revendications

1. Procédé pour concevoir des circuits intégrés ou pour produire un masque de traitement pour un tel circuit intégré,
- procédé dans lequel un plan de conception utilisé pour un plan de masque de traitement est divisé en plusieurs plans de conception séparés (HV, NV) ou on le divise en plusieurs plans de conception séparés et on réalise séparément une topologie respective pour chacun des multiples plans de conception séparés; dans lequel
- au moins une règle de conception (6, 7) est différente et donc autre pour chacun de ces plans de conception séparés (HV, NV);
- on vérifie individuellement ladite au moins une règle de conception différente pour chacun des plans de conception séparés (HV, NV) après la réalisation séparée de la topologie respective dans une vérification séparée des règles de conception pour le plan de conception séparé respectif avec la topologie réalisée respective, et on ne combine qu'ensuite les multiples plans de conception séparés vérifiés en (HV, NV) d'un seul plan de données;
- on produit ensuite à partir de ce plan de données combiné un masque de traitement, qui correspond aux plans de conception séparés vérifiés combinés avec les topologies respectives réalisées séparément;
dans lequel le plan de masque de traitement est un plan de masque de traitement de puissance intelligente à haute tension, prévu pour la production de pistes conductrices (11 à 15) dans un circuit de puissance intelligente à haute tension, dans lequel les pistes conductrices conviennent et sont prévues pour des potentiels différents, dans lequel parmi lesdites pistes conductrices des premières (11,12) pistes sont conçues pour un potentiel élevé dans un premier plan de conception (HV) et parmi lesdites pistes conductrices des deuxièmes (13 à 15) pistes sont conçues pour un potentiel bas, inappropriées pour le potentiel élevé, dans un deuxième plan de conception (NV), et dans lequel au moins une règle de conception non égale (6, 7) vaut pour chacun de ces deux plans de conception.

2. Procédé selon la revendication 1, dans lequel on utilise chacun des plans de conception divisés (NV, HV) dans la topologie globale du circuit.

3. Procédé selon la revendication 1, dans lequel le plan de masque de traitement est un plan de métallisation.

4. Procédé selon la revendication 1, dans lequel on fixe un rapport géométrique entre les pistes conductrices (11 à 15), en particulier une distance minimale (6, 7), comme règle de conception, afin d'empêcher des décharges électriques entre des pistes conductrices, qui se trouvent à des potentiels différents (HV, NV).

5. Procédé selon l'une quelconque des revendications précédentes, dans lequel on fixe comme règle de conception, entre les premières pistes conductrices (11, 12), dont au moins une est appropriée, prévue et utilisable pour un potentiel élevé et qui sont conçues dans le premier plan de conception, une distance minimale (6) plus grande qu'une distance minimale (7) entre les deuxièmes pistes conductrices (13, 14, 15), qui sont prévues exclusivement pour un potentiel bas et ne conviennent pas pour le potentiel élevé, et qui sont conçues dans le deuxième plan de conception.

6. Procédé selon l'une quelconque des revendications précédentes, dans lequel on réalise le premier et le deuxième plans de conception dans un seul plan de traitement avec un seul masque de traitement photolithographique.

7. Procédé selon la revendication 1, dans lequel les deux plans de conception (NV, HV) sont valables pour le même plan de métallisation.

8. Procédé selon la revendication 1, dans lequel les deux plans de conception (HV, NV) concernent un plan de métallisation dans la plaquette ou dans la tranche.
